Europäisches Patentamt

European Patent Office

Office européen des brevets

(19)

(11) **EP 1 591 559 A1**

## (12) EUROPEAN PATENT APPLICATION
published in accordance with Art. 158(3) EPC

(43) Date of publication:
**02.11.2005 Bulletin 2005/44**

(21) Application number: **03777264.7**

(22) Date of filing: **04.12.2003**

(51) Int Cl.7: **C23C 16/455**, C23C 16/08,
C23C 16/34, H01L 21/28,
H01L 21/285

(86) International application number:
**PCT/JP2003/015561**

(87) International publication number:
**WO 2004/050948 (17.06.2004 Gazette 2004/25)**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: **05.12.2002 JP 2002353742
10.06.2003 JP 2003165418**

(71) Applicant: **TOKYO ELECTRON LIMITED
Minato-ku, Tokyo 107-8481 (JP)**

(72) Inventors:
 • **TADA, Kunihiro
 Nirasaki-shi, Yamanashi 407-0192 (JP)**

 • **YOKOI, Hiroaki
 Nirasaki-shi, Yamanashi 407-0192 (JP)**
 • **WAKABAYASHI, Satoshi
 Nirasaki-shi, Yamanashi 407-0192 (JP)**
 • **NARUSHIMA, Kensaku
 Nirasaki-shi, Yamanashi 407-0192 (JP)**

(74) Representative: **Gleiss, Alf-Olav et al
Gleiss Grosse Schrell & Partner
Patentanwälte Rechtsanwälte
Leitzstrasse 45
70469 Stuttgart (DE)**

### (54) FILM FORMATION METHOD AND APPARATUS UTIZING PLASMA CVD

(57)    A film formation method utilizing plasma CVD to form a predetermined thin film on a target substrate (W) includes first and second steps alternately performed each at least once. The first step is arranged to generate first plasma within a process chamber (51) that accommodates the substrate (W) while supplying a compound gas containing a component of the thin film and a reducing gas into the process chamber (51). The second step is arranged to generate second plasma within the process chamber (51) while supplying the reducing gas into the process chamber (51), subsequently to the first step.

EP 1 591 559 A1

FIG.6

**Description**

Technical Field

The present invention relates to a film formation method and apparatus utilizing plasma CVD for forming a predetermined thin film on a target substrate, and particularly to a technique used in a semiconductor process for manufacturing a semiconductor device. The term "semiconductor process" used herein includes various kinds of processes which are performed to manufacture a semiconductor device or a structure having wiring layers, electrodes, and the like to be connected to a semiconductor device, on a target substrate, such as a semiconductor wafer or a glass substrate used for an LCD (Liquid Crystal Display) or FPD (Flat Panel Display), by forming semiconductor layers, insulating layers, and conductive layers in predetermined patterns on the target substrate.

Background Art

In recent years, as a higher density and higher integration degree are required in manufacturing semiconductor devices, multi-layered wiring structures are being increasingly used for circuitry. Under the circumstances, embedding techniques for electrical connection between layers have become important, e.g., at contact holes used as connection portions between a semiconductor substrate and wiring layers, and at via-holes used as connection portions between upper and lower wiring layers.

In general, Al (aluminum), W (tungsten), or an alloy made mainly of these materials is used as the material of connection plugs filling such contact holes and via-holes. In this case, it is necessary to from good contact between a connection plug made of a metal or alloy, and an underlayer, such as an Si substrate or poly-Si layer. For this reason, before the connection plug is embedded, a Ti film is formed on the inner surface of the hole, and a TiN film is further formed thereon as a barrier layer.

Conventionally, methods for forming Ti films or TiN films of this kind utilize PVD (Physical Vapor Deposition), typically sputtering. However, it is difficult to attain high coverage by PVD to satisfy recent devices having a smaller size and higher integration degree. In recent years, design rules have become stricter and brought about decreases in line width and hole-opening diameter, thereby increasing the aspect ratio of holes.

In consideration of this, there are some methods utilizing chemical vapor deposition (CVD) for forming Ti films or TiN films of this kind, because CVD can be expected to provide a film with better quality. Where a Ti-based film is formed by CVD, a semiconductor wafer is heated by a susceptor (worktable), while $TiCl_4$ (titanium tetrachloride) is supplied as a film formation gas. In the case of Ti film formation, $TiCl_4$ is caused to react with $H_2$ (hydrogen). In the case of TiN film formation, $TiCl_4$ is caused to react with $NH_3$ (ammonia).

CVD film formation employing $TiCl_4$ of this kind has a problem in that chlorine may remain in the film, whereby the resistivity of the film increases. Particularly, film formation in recent years is oriented to a lower temperature (for example, in a case where an NiSi layer is present as an underlayer, as described later), but a lower process temperature increases the chlorine concentration in the film.

In order to solve this residual chlorine problem, Jpn. Pat. Appln. KOKAI Publication No. 11-172438 discloses a technique for forming a TiN film, while sequentially performing four steps, as follows: (1) supplying $TiCl_4$ gas; (2) stopping the $TiCl_4$ gas and supplying a purge gas to remove the $TiCl_4$ gas; (3) stopping the purge gas and supplying $NH_3$ gas; and (4) stopping the $NH_3$ gas and supplying a purge gas to remove the $NH_3$ gas. This technique allows a film to be formed at a lower temperature, while decreasing the residual chlorine therein.

On the other hand, as regards Ti films, plasma CVD is used. In this case, it is thought that alternate switching of gases makes it difficult to maintain plasma in a proper state matching with the transmission impedance. For this reason, the method described above for forming a TiN film is not utilized for forming a Ti film to solve the residual chlorine problem. Alternatively, in order to solve the residual chlorine problem in a Ti film, film formation is performed by simultaneously supplying $TiCl_4$ and $H_2$ at a relatively high temperature of 600°C or more.

In recent years, there is a case where a silicide, such as CoSi or NiSi, which has a good contact property, is employed in place of Si for the underlayer of a contact portion, to increase the operation speed of devices. In particular, NiSi has attracted much attention for the underlayer of a contact portion in devices manufactured in accordance with a finer design rule (65-nm generation).

However, where a Ti film is formed on NiSi by CVD, the film formation temperature has to be as low as about 450°C, because NiSi has a low heat resistance. If a low temperature like this is used in conventional methods, a Ti film cannot be formed, or, even if possible, the quality of the film is low with a high residual chlorine concentration. Further, where a Ti film is formed at a low temperature, e.g., about 450°C, and a TiN film is then formed thereon, film separation occurs between the films.

Where a Ti film is formed, a pre-coating consisting of a Ti film is prepared on a gas discharge member or showerhead in advance. Where the film formation temperature is low, the heating temperature of a susceptor for supporting a wafer is low, and thus the temperature of the gas discharge member or showerhead facing the susceptor is also low. Under this condition, a Ti film prepared on the showerhead is not stable and peels off. This deteriorates the quality of a Ti film to be formed.

Disclosure of Invention

An object of the present invention is to provide a film formation method and apparatus utilizing plasma CVD, which allow a film to be formed at a low temperature, while decreasing residual substances in the film even if a low temperature is used for the film formation.

Another object of the present invention is to provide a film formation method and apparatus utilizing plasma CVD, which can prevent film separation between films where a Ti film is formed at a low temperature and a TiN film is then formed thereon.

According to a first aspect of the present invention, there is provided a film formation method utilizing plasma CVD to form a predetermined thin film on a target substrate, the method comprising:

a first step of generating first plasma within a process chamber that accommodates the substrate while supplying a compound gas containing a component of the thin film and a reducing gas into the process chamber; and
a second step of generating second plasma within the process chamber while supplying the reducing gas into the process chamber, subsequently to the first step,

wherein the first and second steps are alternately performed each at least once.

According to a second aspect of the present invention, there is provided a film formation method utilizing plasma CVD to form a Ti film on a target substrate, the method comprising:

a first step of generating first plasma within a process chamber that accommodates the substrate while supplying a Ti compound gas and a reducing gas into the process chamber; and
a second step of generating second plasma within the process chamber while stopping supply of the Ti compound gas and supplying the reducing gas into the process chamber, subsequently to the first step,

wherein the first and second steps are alternately performed each at least once.

According to a third aspect of the present invention, there is provided a film formation method utilizing plasma CVD to form a Ti film or Ti/TiN film on a target substrate, the method comprising:

a first step of generating first plasma within a process chamber that accommodates the substrate while supplying a Ti compound gas and a reducing gas into the process chamber; and
a second step of generating second plasma within the process chamber while stopping supply of the Ti compound gas and supplying the reducing gas and a gas containing N and H into the process chamber, subsequently to the first step,

wherein the first and second steps are alternately performed each at least once.

According to a fourth aspect of the present invention, there is provided a film formation method utilizing plasma CVD to form a Ti/TiN film on a target substrate, the method comprising:

a first stage of forming a Ti film, the first stage comprising

a first step of generating first plasma within a first process chamber that accommodates the substrate while supplying a Ti compound gas and a reducing gas into the first process chamber, and
a second step of generating second plasma within the first process chamber while stopping supply of the Ti compound gas and supplying the reducing gas into the first process chamber, subsequently to the first step,

wherein the first and second steps are alternately performed each at least once; and

a second stage of forming a TiN film after the first stage, the second stage comprising

a third step of generating third plasma within a second process chamber that accommodates the substrate while supplying a Ti compound gas and a reducing gas into the second process chamber, and
a fourth step of generating fourth plasma within the second process chamber while stopping supply of the Ti compound gas and supplying the reducing gas and a gas containing N and H into the second process chamber, subsequently to the third step,

wherein the third and fourth steps are alternately performed each at least once.

According to a fifth aspect of the present invention, there is provided a film formation method utilizing plasma CVD to form a Ti/TiN film on a target substrate, the method comprising:

a first stage of forming a Ti film, the first stage comprising

a first step of generating first plasma within a first process chamber that accommodates the substrate while supplying a Ti compound gas and a reducing gas into the first process chamber, and

a second step of generating second plasma within the first process chamber while stopping supply of the Ti compound gas and supplying the reducing gas into the first process chamber, subsequently to the first step,

wherein the first and second steps are alternately performed each at least once; and

a second stage of supplying a Ti compound gas and a gas containing N and H into a second process chamber that accommodates the substrate, to form a TiN film on the Ti film, after the first stage.

According to a sixth aspect of the present invention, there is provided a film formation method utilizing plasma CVD to form a Ti/TiN film on a target substrate, the method comprising:

a first stage of forming a Ti film, the first stage comprising

a first step of generating first plasma within a first process chamber that accommodates the substrate while supplying a Ti compound gas and a reducing gas into the first process chamber, and
a second step of generating second plasma within the first process chamber while stopping supply of the Ti compound gas and supplying the reducing gas and a gas containing N and H into the first process chamber, subsequently to the first step,

wherein the first and second steps are alternately performed each at least once; and

a second stage of supplying a Ti compound gas and a gas containing N and H into a second process chamber that accommodates the substrate, to form a TiN film on the Ti film, after the first stage.

According to a seventh aspect of the present invention, there is provided a film formation apparatus utilizing plasma CVD to form a predetermined thin film on a target substrate, the apparatus comprising:

a process chamber configured to accommodate the target substrate;
a worktable configured to place the substrate thereon within the process chamber;
a gas supply system configured to supply a compound gas containing a component of the thin film and a reducing gas into the process chamber;
a pair of electrodes configured to generate plasma within the process chamber;
an RF power supply configured to apply an RF power to at least one of the pair of electrodes;
a matching network of an electron matching type configured to match plasma impedance with transmission line impedance;
a group of valves configured to switch ON/OFF of the compound gas and the reducing gas; and
a control system configured to control the RF power supply and the group of valves, so as to alternately perform first and second steps each at least once, wherein the first step is arranged to generate first plasma within the process chamber while supplying the compound gas and the reducing gas into the process chamber, and the second step is arranged to generate second plasma within the process chamber while supplying the reducing gas into the process chamber, subsequently to the first step.

Brief Description of Drawings

FIG. 1 is a structural view schematically showing a film formation system of a multi-chamber type, which includes a Ti film formation apparatus, according to an embodiment of the present invention;
FIG. 2 is a sectional view showing a via-hole of a semiconductor device with a Ti/TiN film formed inside;
FIG. 3 is a sectional view showing a pre-cleaning apparatus disposed in the film formation system shown in FIG. 1;
FIG. 4 is a sectional view showing the Ti film formation apparatus according to an embodiment of the present invention, which is disposed in the film formation system shown in FIG. 1;
FIG. 5 is a graph showing the relationship between the susceptor temperature in film formation and the Ti film resistivity, with and without control on the showerhead temperature;
FIG. 6 is a timing chart showing the timing of gas supply and RF (radio frequency) power supply in a Ti film formation method according to a first embodiment of the present invention;
FIG. 7 is a graph showing an effect of the Ti film formation method according to the first embodiment;
FIG. 8 is a timing chart showing the timing of gas supply and RF power supply in a Ti film formation method according to a second embodiment of the present invention;
FIG. 9 is a graph showing an effect of the Ti film formation method according to the second embodiment;
FIG. 10 is a sectional view showing a TiN film formation apparatus disposed in the film formation system shown in FIG. 1;
FIG. 11 is a timing chart showing the timing of gas supply in a TiN film formation method according to a fourth embodiment of the present invention;

FIG. 12 is a timing chart showing the timing of gas supply and RF power supply in a case where a Ti film and a TiN film are formed in a single apparatus, according to an embodiment of the present invention;

FIG. 13 is a chart showing conditions used for Ti film formation in an experiment;

FIG. 14 is a chart showing conditions used for TiN film formation in an experiment;

FIG. 15 is a graph showing the relationship between the showerhead temperature and the Ti film resistivity, where a Ti film was formed on $SiO_2$; and

FIG. 16 is a graph showing the relationship between the showerhead temperature and the Ti film resistivity, where a Ti film was formed on Si.

Best Mode for Carrying Out the Invention

Embodiments of the present invention will be described hereinafter with reference to the accompanying drawings. In the following description, the constituent elements having substantially the same function and arrangement are denoted by the same reference numerals, and a repetitive description will be made only when necessary.

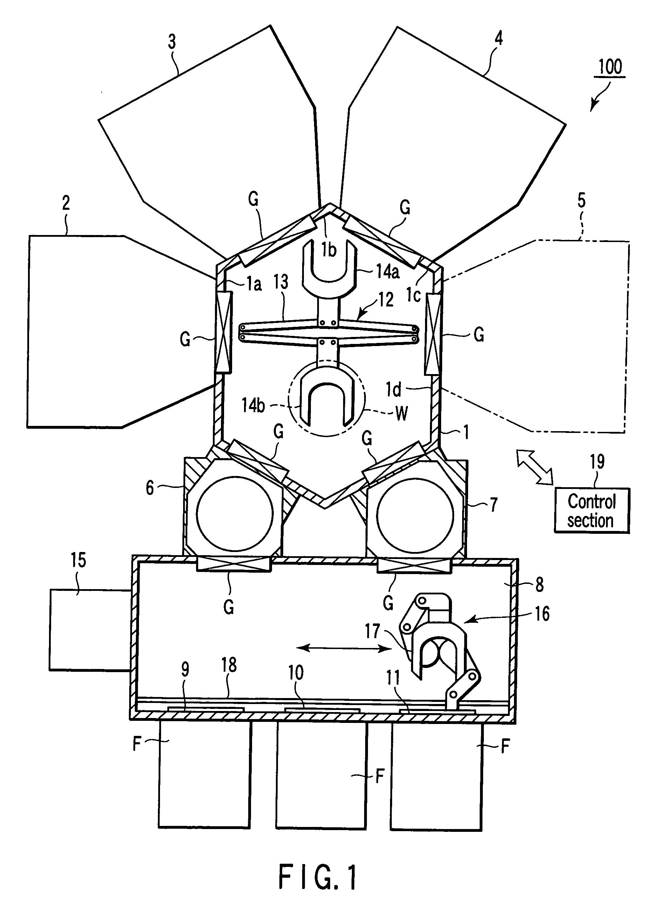

FIG. 1 is a structural view schematically showing a film formation system of a multi-chamber type, which includes a Ti film formation apparatus, according to an embodiment of the present invention.

As shown in FIG. 1, a film formation system 100 includes a wafer transfer chamber 1 with a hexagonal shape. Four sides of the transfer chamber 1 respectively have connection ports 1a, 1b, 1c, and 1d formed therein for respectively connecting predetermined process apparatuses. The connection port 1a is connected to a pre-cleaning apparatus 2 for removing a natural oxide film formed on a target substrate or semiconductor wafer W (i.e., on the surface of an underlayer). The connection port 1b is connected to a Ti film formation apparatus 3 for forming a Ti film by plasma CVD. The connection port 1c is connected to a TiN film formation apparatus 4 for forming a TiN film by thermal CVD. The connection port 1d is connected to no process apparatus, but may be connected to a suitable process apparatus 5, as needed.

The other two sides of the transfer chamber 1 are respectively provided with load-lock chambers 6 and 7. The transfer chamber 1 is connected to a wafer I/O (in/out) chamber 8 through the load-lock chambers 6 and 7. The I/O chamber 8 has three ports 9, 10, and 11 on the side reverse to the load-lock chambers 6 and 7, wherein each of ports is used for connecting a FOUP F for containing wafers W.

The pre-cleaning apparatus 2, Ti film formation apparatus 3, TiN film formation apparatus 4, and load-lock chambers 6 and 7 are connected to the transfer chamber 1 respectively through gate valves G, as shown in FIG. 1. Each process chamber communicates with the transfer chamber 1 when the corresponding gate valve G is opened, and is blocked from the transfer chamber 1 when the corresponding gate valve G is closed. Gate valves G are also disposed between the load-lock chambers 6 and 7 and the I/O chamber 8. Each of the load-lock chambers 6 and 7 communicates with the I/O chamber 8 when the corresponding gate valve G is opened, and is blocked from the I/O chamber 8 when the corresponding gate valve G is closed.

The transfer chamber 1 is provided with a wafer transfer unit 12 disposed therein, for transferring a wafer W to and from the pre-cleaning apparatus 2, Ti film formation apparatus 3, TiN film formation apparatus 4, and load-lock chambers 6 and 7. The transfer unit 12 is disposed at the essential center of the transfer chamber 1, and includes hands 14a and 14b each for supporting a wafer W, respectively at the distal ends of two arm portions 13, which are rotatable and extensible/contractible. The two hands 14a and 14b are connected to the arm portions 13 to face opposite directions. The interior of the transfer chamber 1 is set at a predetermined vacuum level.

The I/O chamber 8 is provided with a HEPA filter disposed (not shown) on the ceiling, and clean air is supplied through the HEPA filter into the I/O chamber 8 in a down flow state. A wafer W is transferred into and from the I/O chamber 8 within a clean air atmosphere under atmospheric pressure. Each of the three ports 9, 10, and 11 of the I/O chamber 8 for connecting a FOUP F is provided with a shutter (not shown). A FOUP, which contains wafers W or is empty, is directly connected to each of the ports 9, 10, and 11, and the shutter is then opened to communicate the FOUP F with the I/O chamber 8 while preventing inflow of outside air. An alignment chamber 15 for performing alignment of a wafer W is disposed on one side of the I/O chamber 8.

The I/O chamber 8 is provided with a wafer transfer unit 16 disposed therein, for transferring a wafer W to and from the FOUPs F and load-lock chambers 6 and 7. The transfer unit 16 includes articulated arm structures respectively having hands 17 at the distal ends. The transfer unit 16 is movable on a rail 18 along a direction in which the FOUPs F are arrayed, to transfer a wafer W placed on each of the hands 17 at the distal ends.

A control section 19 is arranged to control the entire system, such as the operation of the transfer units 12 and 16.

According to the film formation system 100 described above, a wafer W is picked up from one of the FOUPs F by the transfer unit 16 disposed in the I/O chamber 8. At this time, the interior of the I/O chamber 8 is set at a clean air atmosphere under atmospheric pressure. Then, the wafer W is transferred into the alignment chamber 15, which performs alignment of the wafer W. Then, the wafer W is transferred into one of the load-lock chambers 6 and 7. After the load-lock chamber is vacuum-exhausted, the wafer is taken out of this load-lock chamber by the transfer unit 12 disposed in the transfer chamber 1.

The wafer W is then transferred into the pre-cleaning apparatus 2 to remove a natural oxide film from the surface of the underlayer. Then, the wafer W is transferred into the Ti film formation apparatus 3 to perform Ti film formation. Then, the wafer W with a Ti film formed thereon is transferred into the TiN film formation apparatus 4 to perform TiN film formation. Thus, the film formation system 100 performs natural oxide film removal, Ti film formation, and TiN film formation, without breaking the vacuum (without bringing the wafer W out of the vacuum atmosphere).

After film formation, the wafer W is transferred from one of the load-lock chambers 6 and 7 by the transfer unit 12. After the interior of the load-lock chamber is returned to atmospheric pressure, the wafer is transferred from this load-lock chamber into one of the FOUPs F by the transfer unit 16 disposed in the I/O chamber 8. The operation described above is conducted for each wafer W of one lot, thereby completing the one lot process.

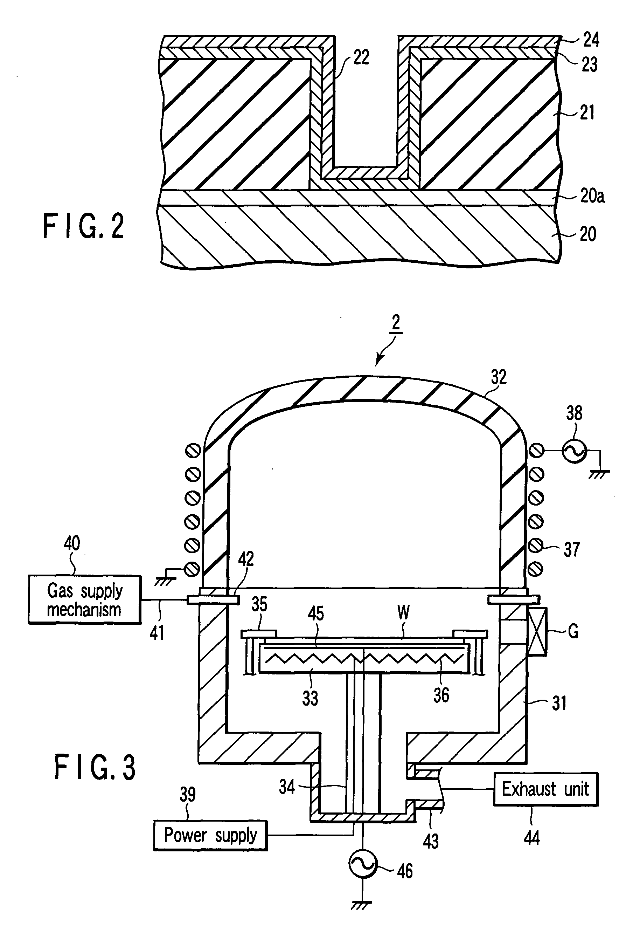

FIG. 2 is a sectional view showing a via-hole of a semiconductor device with a Ti/TiN film formed inside by the film formation process described above.

As shown in FIG. 2, an NiSi layer 20a is disposed on a surface of a substrate conductive layer 20 (underlayer). An inter-level insulating film 21 is disposed on the conductive layer 20. A via-hole 22 is formed in the film 21 to reach the conductive layer 20. A Ti film or contact layer 23 and a TiN film or barrier layer 24 are formed on the inner surface of the via-hole 22. The structure shown in FIG. 2 will be subjected to Al or W film formation by another apparatus, to fill the contact hole 22 (i.e., to form a connection plug), and form a wiring layer.

As described above, where an NiSi layer is present as an underlayer, the film formation temperature has to be set low, because the heat resistance of NiSi is low. However, if the film formation temperature is low, problems arise such that the quality of the film is low with a high residual chlorine concentration, and film separation occurs between Ti and TiN films. On the other hand, film formation methods according to embodiments of the present invention described later can solve these problems even at a low film formation temperature. It should be noted that, film formation methods according to embodiments of the present invention described later can improve the quality of a Ti film and/or TiN film, even where film formation is performed on an underlayer other than an NiSi layer, such as a poly-Si layer, metal silicide layer, e.g., CoSi, capacitor insulating film, low-k film, or Al film.

FIG. 3 is a sectional view showing the pre-cleaning apparatus 2 disposed in the film formation system 100 shown in FIG. 1.

The pre-cleaning apparatus 2 is an apparatus of an inductive coupling plasma (ICP) type. The apparatus 2 is used for removing a natural oxide film on an underlayer made of, e.g., poly-Si or silicide. As shown in FIG. 3, the apparatus 2 includes an essentially cylindrical chamber 31, and an essentially cylindrical bell jar 32 continuously disposed on the chamber 31. The chamber 31 is provided with a susceptor 33 disposed therein and made of a ceramic, such as AlN, for supporting a target substrate or wafer W in a horizontal state. The susceptor 33 is supported by a cylindrical support member 34.

A clamp ring for clamping the wafer W is disposed around the edge of the susceptor 33. The susceptor 33 is provided with a heater 36 built therein, for heating the wafer W. The heater 36 is supplied with a power from the power supply 39 to heat the wafer W to a predetermined temperature. Further, the susceptor 33 is provided with an electrode 45 built therein and formed of molybdenum wires woven into a mesh shape. The electrode 45 is connected to an RF (radio frequency) power supply 46, for supplying a bias.

The bell jar 32 is made of an electrically insulating material, such as quartz or ceramic. A coil 37 used as an antenna member is wound around the bell jar 32. The coil 37 is connected to an RF power supply 38. The RF power supply 38 is set to have a frequency of 300 kHz to 60 MHz, and preferably 450 kHz. An RF power is applied from the RF power supply 38 to the coil 37, so that an inductive electromagnetic field is formed in the bell jar 32.

A gas supply mechanism 40 is arranged to supply a process gas into the chamber 31. The gas supply mechanism 40 includes gas supply sources of predetermined gases, lines from the gas supply sources, switching valves, and mass-flow controllers for controlling flow rates (all of them are not shown). A gas feed nozzle 42 is disposed in the sidewall of the chamber 31. The gas feed nozzle 42 is connected to the gas supply mechanism 40 through a line 41, so that predetermined gases are supplied into the chamber 31 through the gas feed nozzle 42. The valves and mass-flow controllers provided on the lines are controlled by a controller (not shown).

Examples of the process gases are Ar, Ne, and He, each of which may be solely used. $H_2$ may be used along with any one of Ar, Ne, and He, or $NF_3$ may be used along with any one of Ar, Ne, and He. Of them, Ar alone or Ar + $H_2$ is preferable.

An exhaust line 43 is connected to the bottom of the chamber 31. The exhaust line 43 is connected to an exhaust unit 44 including a vacuum pump. The exhaust unit 44 is operated to decrease the pressure within the chamber 31 and bell jar 32 to a predetermined vacuum level. A gate valve G is disposed on the sidewall of the chamber 31 and connected to the transfer chamber 1.

According to the pre-cleaning apparatus 2 described above, a wafer W is transferred into the chamber 31 through the gate valve G in an opened state. The wafer W is placed on the susceptor 33 and clamped by the clamp ring 35. Then, the gate valve G is closed, and the interior of the chamber 31 and bell jar 32 is exhausted to a predetermined vacuum level by the exhaust unit 44. Then, a predetermined gas, such as Ar gas, or Ar gas and $H_2$ gas, is supplied from the gas supply mechanism 40 through the gas feed nozzle 42 into the chamber 31. At the same time, an RF power is applied from the RF power supply 38 to the coil 37 to form an inductive electromagnetic field within the bell jar 32, so as to generate inductive coupling plasma. On the other hand, an RF power is applied from the RF power supply 46 to the susceptor 33 to attract ions onto the wafer W.

The inductive coupling plasma thus acts on the wafer W, and removes a natural oxide film formed on the surface of an underlayer or conductive layer. In this case, since the inductive coupling plasma has a high density, it can efficiently remove the natural oxide film, utilizing a low amount of energy which does not damage the underlayer. A remote plasma mechanism or a microwave plasma mechanism may be used as a low energy plasma source that does not damage the underlayer.

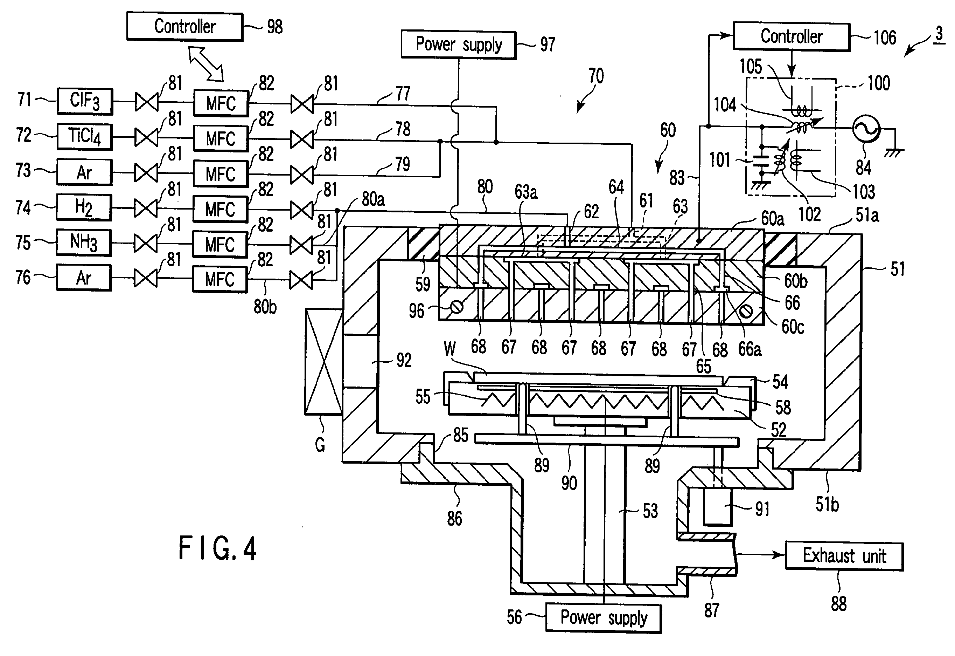

FIG. 4 is a sectional view showing the Ti film formation apparatus 3 according to an embodiment of the present invention, which is disposed in the film formation system 100 shown in FIG. 1.

The Ti film formation apparatus 3 includes an essentially cylindrical airtight chamber 51. The chamber 51 is provided with a susceptor 52 disposed therein for supporting a target substrate or wafer W in a horizontal state. The susceptor 52 is supported by a cylindrical support member 53 disposed therebelow at the center. The susceptor 52 is made of a ceramic, such as AlN, and has a guide ring 54 disposed on the edge for guiding the wafer W. The susceptor 52 is provided with a heater 55 built therein. The heater 55 is supplied with a power from the power supply 56 to heat the target substrate or wafer W to a predetermined temperature. Further, the susceptor 52 is provided with an electrode 58 built therein above the heater 55 and used as a lower electrode.

A showerhead 60 is disposed on the ceiling 51a of the chamber 51 through an insulating member 59. The showerhead 60 is formed of an upper block body 60a, a middle block body 60b, and a lower block body 60c. The lower block body 60c is provided with a ring heater 96 embedded therein near the outer edge. The heater 96 is supplied with a power from the power supply 97 to heat the showerhead 60 to a predetermined temperature.

Delivery holes 67 and 68 for discharging gases are alternately formed in the lower block body 60c. On the other hand, a first gas feed port 61 and a second gas feed port 62 are formed in the upper surface of the upper block body 60a. The first gas feed port 61 is divided into a number of gas passages 63 in the upper block body 60a. The middle block body 60b has gas passages 65 formed therein. The gas passages 63 communicate with the gas passages 65 through communication passages 63a extending horizontally. The gas passages 65 communicate with the discharge holes 67 formed in the lower block body 60c.

The second gas feed port 62 is divided into a number of gas passages 64 in the upper block body 60a. The middle block body 60b has gas passages 66 formed therein, which communicate with the gas passages 64. The gas passages 66 are connected to communication passages 66a extending horizontally in the middle block body 60b. The communication passages 66a communicate with a number of discharge holes 68 formed in the lower block body 60c. The first and second gas feed ports 61 and 62 are respectively connected to gas lines 78 and 80 from a gas supply mechanism 70 described later.

The gas supply mechanism 70 includes a $ClF_3$ gas supply source 71, a $TiCl_4$ gas supply source 72, a first Ar gas supply source 73, an $H_2$ gas supply source 74, an $NH_3$ gas supply source 75, and a second Ar gas supply source 76. The gas supply source 71 is arranged to supply $ClF_3$ gas used as a cleaning gas through a gas supply line 77. The gas supply source 72 is arranged to supply $TiCl_4$ gas used as a Ti-containing gas through a gas supply line 78. The gas supply source 73 is arranged to supply Ar gas through a gas supply line 79. The gas supply source 74 is arranged to supply $H_2$ gas used as a reducing gas through a gas supply line 80. The gas supply source 75 is arranged to supply $NH_3$ gas used as a nitriding gas through a gas supply line 80a. The gas supply source 76 is arranged to supply Ar gas through a gas supply line 80b. The gas supply mechanism 70 also includes an $N_2$ gas supply source (not shown). Each of the gas supply lines is provided with a mass-flow controller 82 and two valves 81 one on either side of the controller 82.

The first gas feed port 61 is connected to the $TiCl_4$ gas supply line 78 extending from the gas supply source 72. The $TiCl_4$ gas supply line 78 is connected to the $ClF_3$ gas supply line 77 extending from the gas supply source 71, and is also connected to the first Ar gas supply line 79 extending from the gas supply source 73. The second gas feed port 62 is connected to the $H_2$ gas supply line 80 extending from the gas supply source 74. The $H_2$ gas supply line 80 is connected to the $NH_3$ gas supply line 80a extending from the gas supply source 75, and is also connected to the second Ar gas supply line 80b extending from the gas supply source 76.

According to this arrangement, during a process, $TiCl_4$ gas from the gas supply source 72 and Ar gas from the gas supply source 73 are supplied into the $TiCl_4$ gas supply line 78. This mixture gas flows through the first gas feed port 61 into the showerhead 60, and is then guided through the gas passages 63 and 65 and discharged into the chamber 51 through discharge holes 67. On the other hand, $H_2$ gas used as a reducing gas from the gas supply source 74 and Ar gas from the gas supply source 76 are supplied into the $H_2$ gas supply

line 80. This mixture gas flows through the second gas feed port 62 into the showerhead 60, and is then guided through the gas passages 64 and 66 and discharged into the chamber 51 through discharge holes 68.

In other words, the showerhead 60 is of a post-mix type in which $TiCl_4$ gas and $H_2$ gas are supplied into the chamber 51 separately from each other. $TiCl_4$ gas and $H_2$ gas react with each other after they are discharged and mixed. Where a nitriding process is performed, $NH_3$ gas from the gas supply source 75 is supplied simultaneously with $H_2$ gas and Ar gas, into the gas line 80 for $H_2$ gas used as a reducing gas. This mixture gas flows through the second gas feed port 62 into the showerhead 60, and is then discharged through discharge holes 68. The valves 81 and mass-flow controllers 82 for the gases are controlled by a controller 98, so that alternate gas supply is performed, as described later.

The showerhead 60 is connected to a transmission line 83. The transmission line 83 is connected to an RF power supply 84 through a matching network 100 of the electron matching type. During film formation, an RF power is applied from the RF power supply 84 through the transmission line 83 to the showerhead 60. When the RF power is applied from the RF power supply 84, an RF electric field is generated between the showerhead 60 and electrode 58. Due to the presence of the RF electric field, a gas supplied into the chamber 51 is turned into plasma, which is used for Ti film formation. The transmission line 83 is connected to a controller 106. The controller 106 is arranged to detect through a transmission line 83 a reflected wave from plasma generated in the chamber 51, and control the matching network 100 of the electron matching type to adjust the reflected wave from plasma to be zero or minimum. The RF power supply 84 used here has a frequency of 400 kHz to 13.56 MHz.

The matching network 100 of the electron matching type includes a capacitor 101 and two coils 102 and 104, as in ordinary matching networks. The reactance of the two coils 102 and 104 is variable in by electrically changing magnetic fields respectively from induction coils 103 and 105. Accordingly, the matching network 100 of the electron matching type includes no mechanically moving parts used in ordinary matching networks. As a consequence, the matching network 100 can adjust to the plasma very quickly, and reach a steady state in about 0.5 seconds, which is one tenth of that of ordinary matching networks. For this reason, this matching network 100 is suitable for alternately supplying gases while forming plasma, as described later.

The bottom wall 51b of the chamber 51 has a circular opening 85 formed at the center. An exhaust chamber 86 is formed at the bottom wall 51b to cover the opening 85 and extend downward. An exhaust unit 88 is connected to one side of the exhaust chamber 86 through the exhaust line 87. The exhaust unit 88 can be operated to decrease the pressure of the chamber 51 to a predetermined vacuum level.

The susceptor 52 is provided with three (only two of them are shown) wafer support pins 89 for supporting a wafer W and moving it up and down. The support pins 89 are fixed on a support plate 90 and can project and retreat relative to the surface of the susceptor 52. The support pins 89 are moved up and down with the support plate 90 by a driver mechanism 91, such as an air cylinder. The chamber 51 has a transfer port 92 formed on the sidewall, for transferring a wafer W to and from the transfer chamber 1, and a gate valve G for opening/closing the transfer port 92.

Next, an explanation will be given of a Ti film formation method performed in this apparatus.

At first, the interior of the chamber 51 is exhausted to a pressure of 667 Pa. The susceptor 52 is heated up to a temperature of 350 to 700°C by the heater 55. The showerhead 60 is heated up to a temperature of 450°C or more, such as about 470 to 490°C, by the heater 96.

In this state, $TiCl_4$ gas and Ar gas are supplied from the gas supply sources 72 and 73 to the first gas feed port 61, and discharged through the gas discharge holes 67. Further, $H_2$ gas and Ar gas are supplied from the gas supply sources 74 and 76 to the second gas feed port 62, and discharged through the gas discharge holes 68. Furthermore, an RF power is applied from the RF power supply 84 to the showerhead 60. With this arrangement, these gases are turned into plasma within the chamber 51, and a Ti film pre-coating is formed on the members within the chamber 51, such as the inner wall of the chamber 51 and the showerhead 60.

At this time, $TiCl_4$ gas is set at a flow rate of 0.001 to 0.03 L/min (1 to 30 sccm), $H_2$ gas at a flow rate of 0.5 to 5 L/min (500 to 5000 sccm), and Ar gas at a flow rate of 0.3 to 3.0 L/min (300 to 3000 sccm), approximately. The interior of the chamber 51 is set at a pressure of about 66.6 to 1333 Pa, and preferably about 133.3 to 666.5 Pa. The RF power supply 84 is set at a power of about 200 to 2000W, and preferably about 500 to 1500W.

Thereafter, the gate valve G is opened while the temperatures of the susceptor 52 and showerhead 60 are maintained. Then, a wafer W is transferred by the hand 14a or 14b of the transfer unit 12 from the transfer chamber 1 in a vacuum state, through the transfer port 92, into the chamber 51, and is placed on the support pins 89 projecting from the susceptor 52. Then the hand 14a or 14b is returned into the transfer chamber 1, and the gate valve G is closed, while the support pins 89 are moved down to place the wafer W on the susceptor 52.

Thereafter, Ti film formation is started on the wafer W. Incidentally, the conventional technique includes no heater in the showerhead 60, and thus the showerhead 60 is indirectly heated by the susceptor 52. In this case, the susceptor 52 needs to be set at a temperature of about 550°C or more, to ensure that the showerhead 60 has a temperature of about 450°C or more at which the Ti film pre-coating does not peel off. This condition causes no problem where the underlayer is an Si or CoSi layer. However, where the underlayer is an NiSi layer, the film formation temperature is limited to about 450 to 500°C, and thus the conventional CVD-Ti film formation cannot be applied thereto. Further, there may be a case where a Ti film is formed on a low-k film or further on an Al film, which requires the film formation temperature to be 500°C or less.

In this respect, the Ti film formation apparatus 3 according to this embodiment of the present invention is arranged to heat the showerhead 60 by the heater 96. The showerhead 60 can be thereby set at a temperature of about 440°C or more for preventing film separation, without reference to the temperature of the susceptor 52. As a consequence, even where the underlayer is made of a material, such as NiSi or low-k film, which requires the film formation temperature to be lower than 500°C, a Ti film is formed without causing film separation on the showerhead 60. The Ti film thus formed can have a low resistivity and good quality.

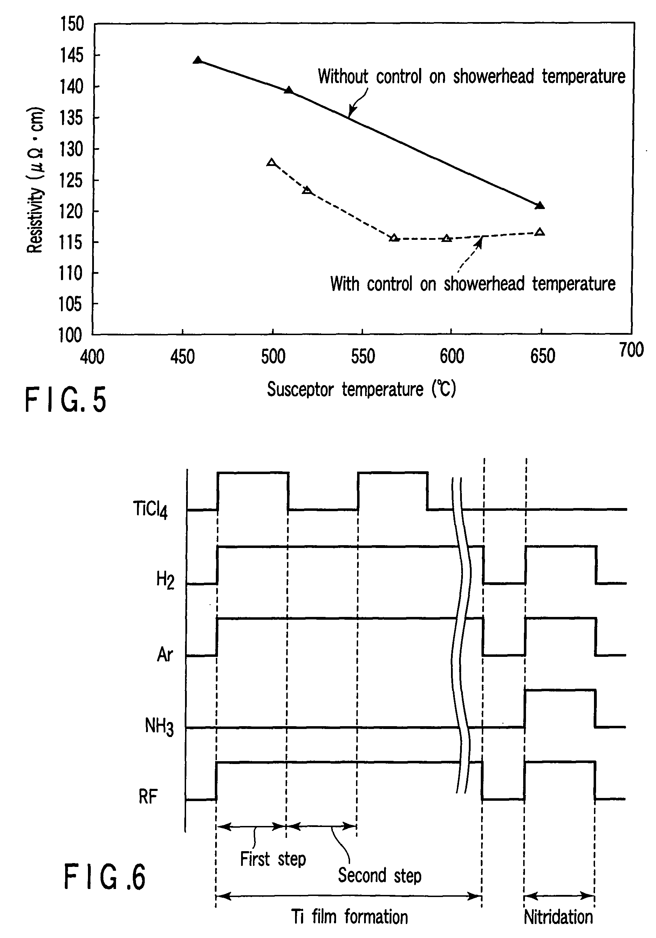

FIG. 5 is a graph showing the relationship between the susceptor temperature in film formation and the Ti film resistivity, with and without control on the temperature of the showerhead 60. In this experiment, the temperature of the showerhead 60 was controlled to be heated at 450°C or more by the heater 96 disposed in the showerhead 60. A Ti film was formed on an underlayer formed of an $SiO_2$ film. As shown in FIG. 5, it was confirmed that the Ti film formed had a low resistivity and good quality, where the temperature of the showerhead 60 was controlled at 450°C or more by the heater 96.

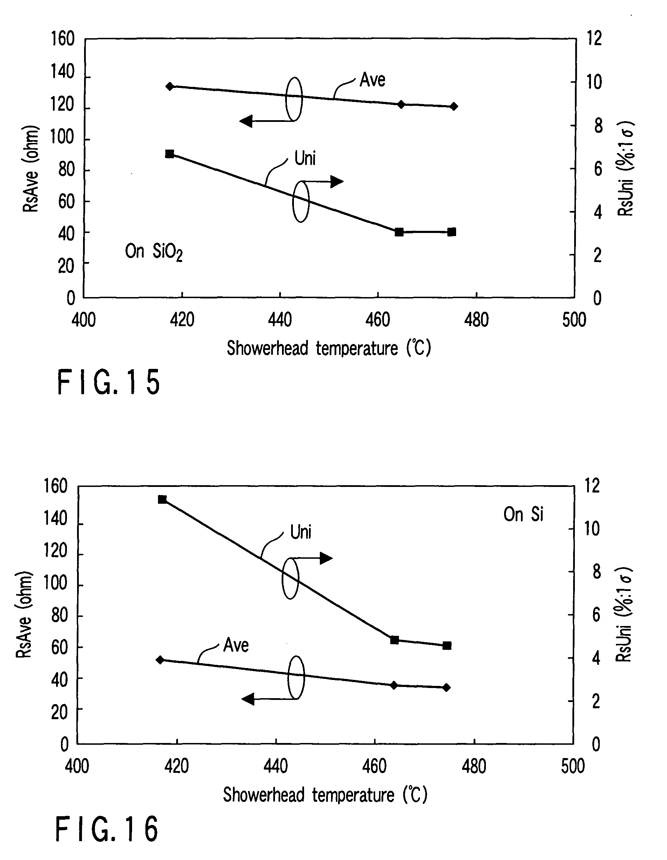

FIG. 15 is a graph showing the relationship between the temperature of the showerhead 60 and the Ti film resistivity, where a Ti film was formed on $SiO_2$. FIG. 16 is a graph showing the relationship between the temperature of the showerhead 60 and the Ti film resistivity, where a Ti film was formed on Si. In FIGS. 15 and 16, the left vertical axis denotes the average value RsAve (ohm) of resistivity, and the right vertical axis denotes the planar uniformity RsUni (%:1σ) of resistivity. In this experiment, the temperature of the susceptor 52 was set at 600°C. The surface temperature of the showerhead 60 was set at three different temperatures of 416.6°C, 464.3°C, and 474.9°C. As shown in FIGS. 15 and 16, it was confirmed that the Ti film formed had a low resistivity and high planar uniformity, where the temperature of the showerhead 60 was controlled at 440°C or more, and preferably 460°C or more.

In practice, Ti film formation is performed, according to first and second embodiments described below, after the wafer W is placed on the susceptor 52, as described above.

FIG. 6 is a timing chart showing the timing of gas supply and RF power supply in a Ti film formation method according to a first embodiment of the present invention.

In this embodiment, the heater 55 and heater 96 are maintained in the same conditions as in the precoating. In this state, as shown in the timing chart of FIG. 6, at first, an RF power is applied from the RF power supply 84 to the showerhead 60. At the same time, $TiCl_4$ gas, Ar gas, $H_2$ gas, and Ar gas are supplied respectively from the gas supply sources 72, 73, 74, and 76. By doing so, a first step is performed to turn these gases into plasma (first plasma), and maintain this state for 1 to 20 seconds, and preferably 2 to 10 seconds.

Then, only the $TiCl_4$ gas is stopped, while the RF power, Ar gas, and $H_2$ gas are maintained. By doing so, a second step, which is a reducing process using plasma (second plasma) of Ar gas and $H_2$ gas, is performed for 2 to 60 seconds, and preferably 5 to 40 seconds. This second plasma process is preferably set to have a longer processing time than the first plasma process.

The first and second steps are alternately repeated a plurality of times, and preferably three times or more, such as 12 to 24 times. The gas switching for this is performed by valve switching under the control of the controller 98. At this time, in accordance with instructions from the controller 106, the matching network 100 of the electron matching type follows change in plasma and automatically matches the plasma impedance with the transmission line impedance. As a consequence, even if the plasma state varies due to gas switching, a good plasma state is maintained.

A Ti film is thus formed to have a predetermined thickness. At this time, $TiCl_4$ gas is set at a flow rate of 0.001 to 0.03 L/min (1 to 30 sccm), $H_2$ gas at a flow rate of 0.5 to 5 L/min (500 to 5000 sccm), and Ar gas at a flow rate of 0.3 to 3.0 L/min (300 to 3000 sccm), approximately. The interior of the chamber 51 is set at a pressure of about 66.6 to 1333 Pa, and preferably about 133.3 to 666.5 Pa. The RF power supply 84 is set at a power of about 200 to 2000W, and preferably about 500 to 1500W.

As described above, a first step of performing film formation using $TiCl_4$ gas + Ar gas + $H_2$ gas + plasma, and a second step of performing reduction using Ar gas + $H_2$ gas + plasma are alternately performed a plurality of times in a relatively short time. In this case, the reducing action of reducing $TiCl_4$ is enhanced, and the residual chlorine concentration in the Ti film is thereby decreased, in accordance with the following reaction formulas (1) and (2). It should be noted that the reaction formulas (1) and (2) proceed in the first step, while only the reaction formula (2) proceeds in the second step.

$$TiCl_4 + Ar^* \rightarrow TiClX \ (X = 2 \ to \ 3) + Ar^* \qquad (1)$$

$$TiClX \ (X = 2 \ to \ 3) + H \rightarrow Ti + HCl \qquad (2)$$

Particularly, where the wafer temperature is as low as 450°C or less, residual chlorine in the Ti film tends to increase. Even if such a low temperature is used, the sequence according to the first embodiment can decrease the residual chlorine concentration, thereby providing a high quality film with a low resistivity.

Then, the RF power and gases are stopped to finish the Ti film formation, and a nitriding process starts. In this nitriding process, as shown in FIG. 6, an RF power is applied from the RF power supply 84 to showerhead 60. At the same time, Ar gas, $H_2$ gas, $NH_3$ gas, and Ar gas are supplied respectively from the gas supply sources 73, 74, 75, and 76. By doing so, these gases are turned into plasma, which is used to nitride the surface of the Ti film.

The processing time of this process is set to be about 30 to 60 seconds. At this time, $H_2$ gas is set at a flow rate of 0.5 to 5 L/min (500 to 5000 sccm), Ar gas at a flow rate of 0.3 to 3.0 L/min (300 to 3000 sccm), and $NH_3$ gas at a flow rate of 0.5 to 2.0 L/min (500 to 2000 sccm), approximately. The interior of the chamber 51 is set at a pressure of about 66.6 to 1333 Pa, and preferably about 133.3 to 666.5 Pa. The RF power supply 84 is set at a power of about 200 to 2000W, and preferably about 500 to 1500W.

With this nitriding process, the Ti film is prevented from being deteriorated due to, e.g., oxidization. Further, the Ti film is well adhered with a TiN film subsequently formed. However, this nitriding process is not indispensable.

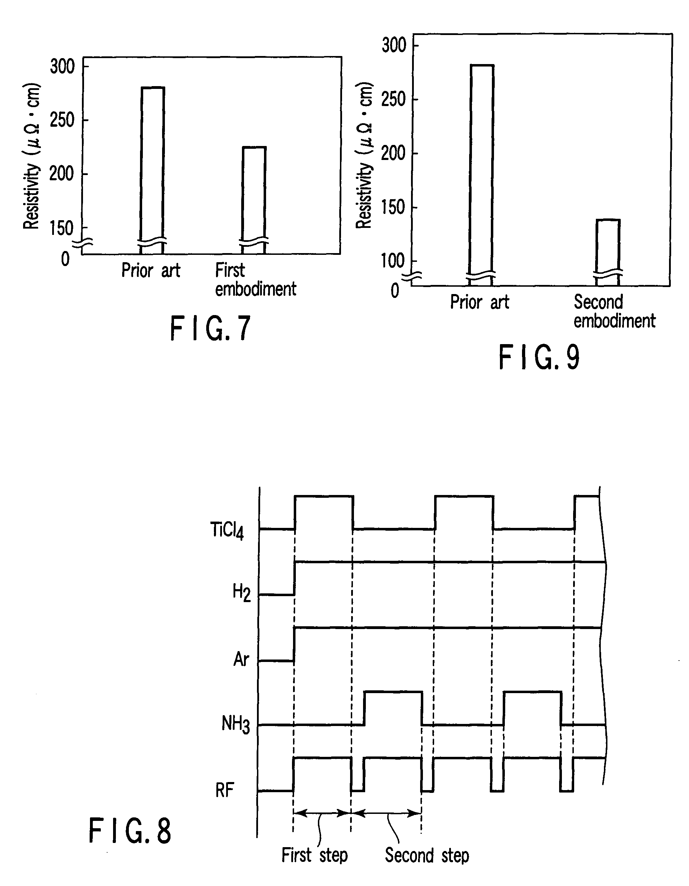

FIG. 7 is a graph showing an effect of the Ti film formation method according to the first embodiment. In this experiment, a Ti film formed in accordance with the first embodiment was compared with a Ti film formed in accordance with a conventional method. For either case, a Ti film was formed to have a thickness of 10 nm on Si while the susceptor was set at a temperature of 500°C, and the resistivity of the film thus formed was measure. As a sample according to the first embodiment, a cycle of the first step for 4 seconds and the second step for 4 seconds was repeated 16 times to form a Ti film. As a result, as shown in FIG. 7, the Ti film formed by the conventional method had a high resistivity of 280 μΩ·cm due to residual chlorine, while the Ti film formed in accordance with the first embodiment had a lower resistivity of 225 μΩ·cm.

FIG. 8 is a timing chart showing the timing of gas supply and RF power supply in a Ti film formation method according to a second embodiment of the present invention.

In this embodiment, the heater 55 and heater 96 are maintained in the same conditions as in the precoating. In this state, as shown in the timing chart of FIG. 8, at first, an RF power is applied from the RF power supply 84 to the showerhead 60. At the same time, $TiCl_4$ gas, Ar gas, $H_2$ gas, and Ar gas are supplied respectively from the gas supply sources 72, 73, 74, and 76. By doing so, a first step is performed to turn these gases into plasma (first plasma), and maintain this state for 1 to 20 seconds, and preferably 4 to 8 seconds.

Then, the RF power and $TiCl_4$ gas are stopped, while the Ar gas and $H_2$ gas are maintained. Then, $NH_3$ gas starts being supplied from the gas supply source 75, and the RF power restarts being applied. By doing so, a second step, which is a reducing and nitriding process using plasma (second plasma) of Ar gas, $H_2$ gas, and $NH_3$ gas, is performed for 1 to 20 seconds, and preferably 4 to 8 seconds. This second step is preferably set to have a longer processing time than the first step.

The first and second steps are alternately repeated a plurality of times, and preferably three times or more, such as 12 to 24 times. The gas switching for this is performed by valve switching under the control of the controller 98. At this time, in accordance with instructions from the controller 106, the matching network 100 of the electron matching type follows change in plasma and automatically matches the plasma impedance with the transmission line impedance. As a consequence, even if the plasma state varies due to gas switching, a good plasma state is maintained.

A Ti film is thus formed to have a predetermined thickness. At this time, $TiCl_4$ gas is set at a flow rate of 0.001 to 0.03 L/min (1 to 30 sccm), $H_2$ gas at a flow rate of 0.5 to 5 L/min (500 to 5000 sccm), $NH_3$ gas at a flow rate of 0.3 to 3.0 L/min (300 to 3000 sccm), and Ar gas at a flow rate of 0.3 to 3.0 L/min (300 to 3000 sccm), approximately. The interior of the chamber 51 is set at a pressure of about 66.6 to 1333 Pa, and preferably about 133.3 to 666.5 Pa. The RF power supply 84 is set at a power of about 200 to 2000W, and preferably about 500 to 1500W.

As described above, a first step of performing film formation using $TiCl_4$ gas + Ar gas + $H_2$ gas + plasma, and a second step of performing reduction and nitridation using $NH_3$ gas + Ar gas + $H_2$ gas + plasma are alternately performed a plurality of times in a relatively short time. In this case, the reducing action of reducing $TiCl_4$ is enhanced, and the residual chlorine concentration in the Ti film is thereby decreased, in accordance with the reaction formulas described above. Further, nitridation of the Ti film is effectively performed to improve the adhesiveness and barrier property of the Ti film and decrease residual substances, such as chlorine, thereby providing a high quality Ti film with a low resistivity. Particularly, where the wafer temperature is as low as 450°C or less, residual chlorine in the Ti film tends to increase. Even if such a low temperature is used, the sequence according to the second embodiment can decrease the residual chlorine concentration, thereby providing a high quality film with a low resistivity.

In the second embodiment, a Ti/TiN film may be formed by controlling the amount of $NH_3$ gas and the processing time of the second step. Specifically, where the amount of supplied $NH_3$ gas is small or the processing time of the second step is short, the nitridation is subsidiary, and the formed film functions as a Ti film. On the other hand, where the amount of supplied $NH_3$ gas is large or the processing time of the second step is long, a TiN film is formed to have a sufficient thickness, so that a multi-layered film is obtained by alternately stacking Ti films and TiN films. This multi-layered film functions as a Ti/TiN film, i.e., a Ti/TiN film can be formed by one apparatus.

FIG. 9 is a graph showing an effect of the Ti film formation method according to the second embodiment. In this experiment, a Ti film formed in accordance with the second embodiment was compared with a Ti film formed in accordance with a conventional method. For either case, a Ti film was formed to have a thickness of 10 nm on Si while the susceptor was set at a temperature of 500°C, and the resistivity of the film thus formed was measured. As a sample according to the second embodiment, a cycle of the first step for 4 seconds and the second step for 4 seconds was repeated 16 times to form a Ti film. As a result, as shown in FIG. 9, the Ti film formed by the conventional method had a high resistivity of 280 $\mu\Omega\cdot$cm due to residual chlorine, while the Ti film formed in accordance with the second embodiment had a lower resistivity of 130 $\mu\Omega\cdot$cm. In this case, the Ti film was probably nitrided in the second step, and a TiN film was thereby slightly formed. Accordingly, it is thought that some decrease in the resistivity of the sample according to the second embodiment was due to formation of the TiN film.

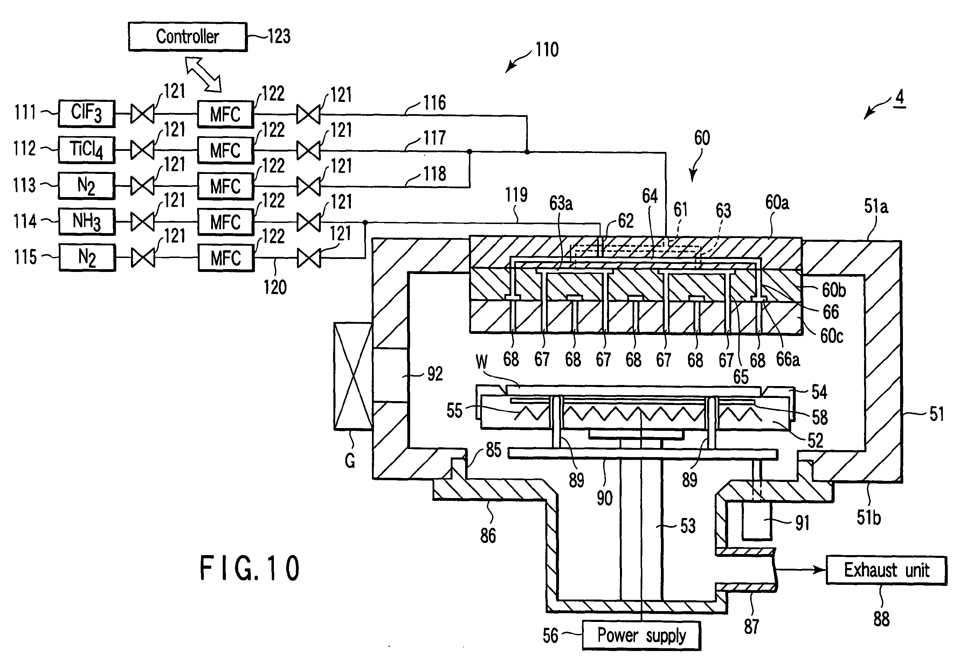

FIG. 10 is a sectional view showing the TiN film formation apparatus 4 disposed in the film formation system shown in FIG. 1. The TiN film formation apparatus 4 has almost the same structure as the Ti film formation apparatus 3, except that there are some differences in gases supplied from the gas supply mechanism, and in arrangements made without plasma generating means and showerhead heating means. Accordingly, the constituent elements of this apparatus are denoted by the same reference numerals as FIG. 4, and their explanation will be omitted except for the gas supply mechanism.

The gas supply mechanism 110 includes a $ClF_3$ gas supply source 111, a $TiCl_4$ gas supply source 112, a first $N_2$ gas supply source 113, an $NH_3$ gas supply source 114, and a second $N_2$ gas supply source 115. The gas supply source 111 is arranged to supply $ClF_3$ gas used as a cleaning gas through a gas supply line 116. The gas supply source 112 is arranged to supply $TiCl_4$ gas used as a Ti-containing gas through a gas supply line 117. The gas supply source 113 is arranged to supply $N_2$ gas through a gas supply line 118. The gas supply source 114 is arranged to supply $NH_3$ gas used as a nitriding gas through a gas supply line 119. The gas supply source 115 is arranged to supply $N_2$ gas through a gas supply line 120. The gas supply mechanism 110 also includes an Ar gas supply source (not shown). Each of the gas supply lines is provided with a mass-flow controller 122 and two valves 121 one on either side of the controller 122.

The first gas feed port 61 of the showerhead 60 is connected to the $TiCl_4$ gas supply line 117 extending from the gas supply source 112. The $TiCl_4$ gas supply line 117 is connected to the $ClF_3$ gas supply line 116 extending from the gas supply source 111, and is also connected to the first $N_2$ gas supply line 118 extending from the gas supply source 113. The second gas feed port 62 is connected to the $NH_3$ gas supply line 119 extending from the gas supply source 114. The $NH_3$ gas supply line 119 is connected to the second $N_2$ gas supply line 120 extending from the gas supply source 115.

According to this arrangement, during a process, $TiCl_4$ gas from the gas supply source 112 and $N_2$ gas from the gas supply source 113 are supplied into the $TiCl_4$ gas supply line 117. This mixture gas flows through the first gas feed port 61 into the showerhead 60, and is then guided through the gas passages 63 and 65 and discharged into the chamber 51 through discharge holes 67. On the other hand, $NH_3$ gas used as a nitriding gas from the gas supply source 114 and $N_2$ gas from the gas supply source 115 are supplied into the $NH_3$ gas supply line 119. This mixture gas flows through the second gas feed port 62 into the showerhead 60, and is then guided through the gas passages 64 and 66 and discharged into the chamber 51 through discharge holes 68.

In other words, the showerhead 60 is of a postmix type in which $TiCl_4$ gas and $NH_3$ gas are supplied into the chamber 51 completely separately from each other. $TiCl_4$ gas and $NH_3$ gas react with each other after they are discharged and mixed. The valves 121 and mass-flow controllers 122 for the gases are controlled by a controller 123.

Next, an explanation will be given of a TiN film formation method performed in this apparatus.

At first, the interior of the chamber 51 is exhausted by the exhaust unit 88 at full load. In this state, $N_2$ gas is supplied from the gas supply sources 113 and 115 through the showerhead 60 into the chamber 51. At the same time, the susceptor 52 and the interior of the chamber 51 is heated up by the heater 55. When the temperature becomes stable, $N_2$ gas, $NH_3$ gas, and $TiCl_4$ gas are supplied respectively from gas supply sources 113, 114, and 112 through the showerhead 60 into the chamber 51 at predetermined flow rates. By doing so, pre-flow is performed to stabilize the flow rates, while $TiCl_4$ gas and so forth are exhausted and the pressure within the chamber is kept at a predetermined value. Then, a TiN film pre-coating is formed on the members within the chamber 51, such as the surface of the susceptor 52, the inner wall of the chamber 51, and the showerhead 60, while they are heated by the heater 55, and the gas flow rates and pressure are maintained.

Then, the $NH_3$ gas and $TiCl_4$ gas are stopped to finish the pre-coating process. Then, $N_2$ gas is supplied as a purge gas from the gas supply sources 113 and 115 into the chamber 51 to purge the interior of the chamber 51. Then, as needed, $N_2$ gas and $NH_3$ gas are

supplied to perform a nitiriding process on the surface of the TiN thin film thus formed, so as to remove chlorine in the film, thereby obtaining a stable TiN film.

Thereafter, the interior of the chamber 51 is quickly vacuum-exhausted by the exhaust unit 88 at full load, and the gate valve G is opened. Then, a wafer W is transferred by the transfer unit 12 from the transfer chamber 1 in a vacuum state, through the transfer port 92, into the chamber 51. Then, $N_2$ gas is supplied into the chamber 51 and the wafer W is heated. When the wafer temperature becomes essentially stable, TiN film formation is started.

The TiN film formation is performed in accordance with third and fourth embodiments, as described below.

In the third embodiment, at first, $TiCl_4$ gas pre-flow is preformed while $N_2$ gas and $NH_3$ gas are supplied at predetermined flow rates through the showerhead 60, and the pressure within the chamber is kept at a predetermined value. Then, $TiCl_4$ gas is supplied into the chamber while the gas flow rates and the pressure within the chamber 51 are maintained. At this time, the wafer W is heated by the heater 55, so that a TiN film is formed by thermal CVD on the Ti film on the wafer W.

As described above, $N_2$ gas, $NH_3$ gas, and $TiCl_4$ gas are supplied for a predetermined time, so that a TiN film is formed to have a predetermined thickness. At this time, $TiCl_4$ gas is set at a flow rate of 0.01 to 0.10 L/min (10 to 100 sccm), $N_2$ gas at a flow rate of 0.3 to 3.0 L/min (300 to 3000 sccm), and $NH_3$ gas at a flow rate of 0.03 to 2 L/min (30 to 2000 sccm), approximately. The interior of the chamber 51 is set at a pressure of about 40 to 1333 Pa, and preferably about 200 to 1333 Pa. The wafer W is heated at a temperature of about 400 to 700°C, and preferably about 500°C.

Then, the $NH_3$ gas and $TiCl_4$ gas are stopped to finish the film formation step. Then, $N_2$ gas is supplied as a purge gas at a flow rate preferably of 0.5 to 10 L/min through a purge gas line (not shown) to purge the interior of the chamber 51. Then, $N_2$ gas and $NH_3$ gas are supplied to perform a nitiriding process on the surface of the TiN thin film formed on the wafer W. At this time, $N_2$ gas is supplied from one or both of the first and second $N_2$ gas supply sources 113 and 115. It should be noted that this nitiriding process is not indispensable. After a predetermined time has elapsed, the $N_2$ gas and $NH_3$ gas are gradually stopped. When these gases are stopped, the film formation process is finished.

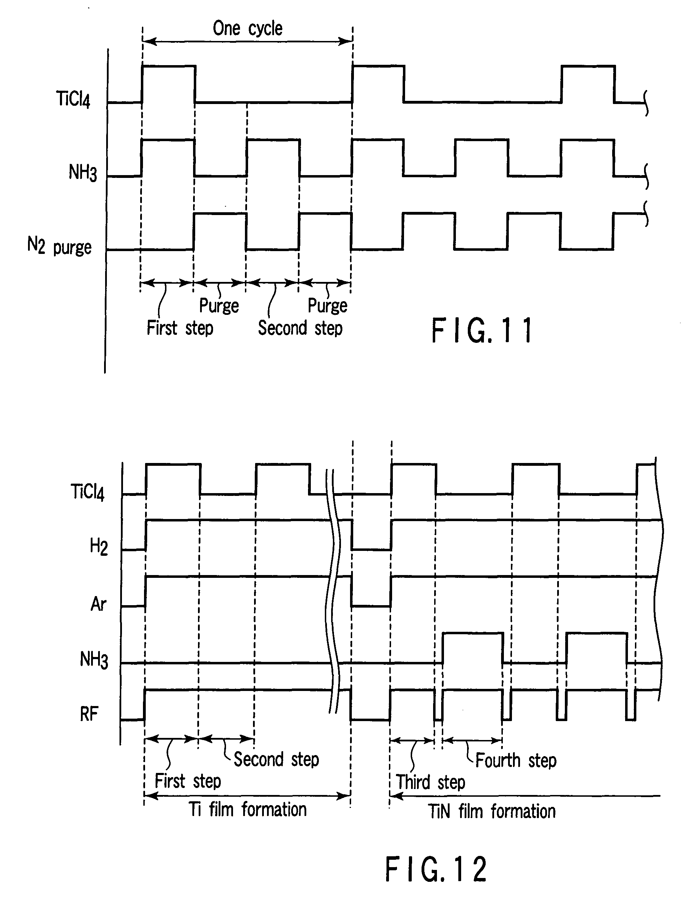

FIG. 11 is a timing chart showing the timing of gas supply in a TiN film formation method according to a fourth embodiment of the present invention.

In this embodiment, the wafer W is kept at a temperature of about 400 to 700°C by the heater 55, as in the embodiment described above. In this state, as shown in the timing chart of FIG. 11, at first, $TiCl_4$ gas and $NH_3$ gas are supplied respectively from the gas supply sources 112 and 114 while they are carried by $N_2$ gas supplied from the gas supply sources 113 and 115, respectively. By doing so, a first step is performed for 2 to 8 seconds to from a TiN film by thermal CVD.

Then, the $TiCl_4$ gas and $NH_3$ gas are stopped, and $N_2$ gas is supplied as a purge gas through a purge gas line (not shown) into the chamber 51 to purge the interior of the chamber 51 for 0.5 to 20 seconds. Thereafter, $NH_3$ gas is supplied from the gas supply source 114, while it is carried by $N_2$ gas supplied from the gas supply source 115, so that a second step is performed for 0.5 to 8 seconds to perform annealing. Then, the $NH_3$ gas is stopped, and $N_2$ gas is supplied as a purge gas through a purge gas line (not shown) into the chamber 51 to purge the interior of the chamber 51 for 0.5 to 20 seconds.

A cycle consisting of the steps described above is repeated a plurality of times, and preferably three times or more, such as 12 to 24 times. The gas switching for this is performed by valve switching under the control of the controller 123.

As described above, the gas flows are alternately switched, so that a TiN film is formed in the first step, and is then efficiently subjected to de-chlorine treatment by annealing in the second step (by reduction and nitridation of $TiCl_4$). As a consequence, the residual chlorine in the film is remarkably decreased, and thus, even if a low temperature is used in the film formation, it is possible to provide a high quality TiN film with a low residual chlorine concentration.

Either of the two methods of forming a TiN film described above can be applied to a film to be formed on an underlayer consisting of a Ti film, which has been formed by an alternately gas flow process such as the first or second embodiment described above. In this case, the Ti film and TiN film cause essentially no film separation therebetween, and thus the quality of the entire Ti/TiN film becomes better than the conventional films. It should be noted that, where a Ti film is formed by a conventional gas flow at a low temperature while a TiN film is formed by either one of the methods described above, the Ti film and TiN film frequently cause film separation therebetween.

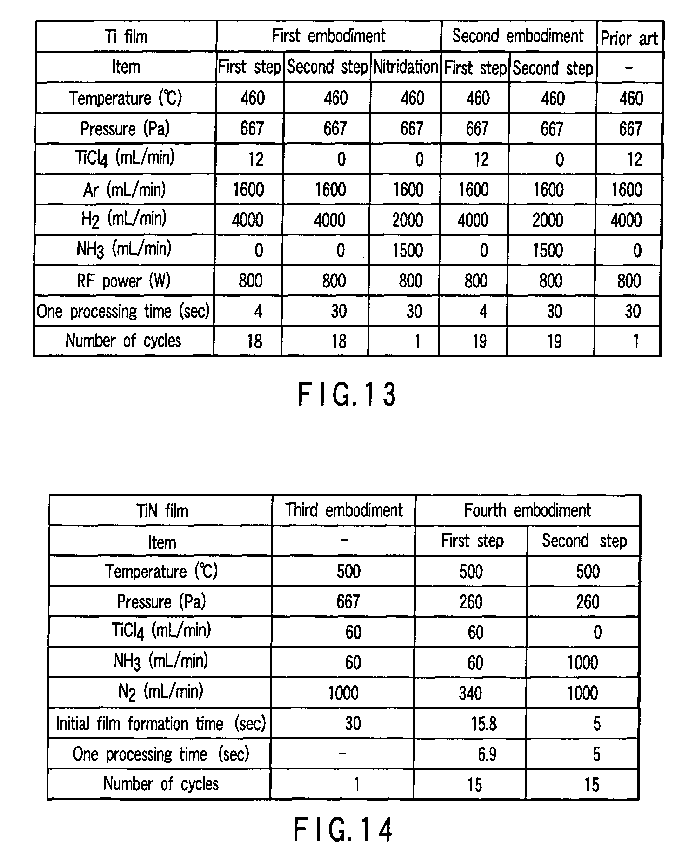

An experiment was conducted in which samples were prepared by pre-cleaning, Ti film formation, and TiN film formation all performed in situ, using the film formation system shown in FIG. 1, and were examined in terms of film separation therein. For these samples, a Ti film was formed by a method according to each of the first and second embodiments, and a TiN film was formed thereon by a method according to each of the third and fourth embodiments. FIG. 13 is a chart showing conditions used for the Ti film formation in this experiment. FIG. 14 is a chart showing conditions used for the TiN film formation in this experiment. Further, comparative samples were prepared, such that a Ti film was formed under conventional film formation conditions (also shown in FIG. 13) and a TiN film was formed thereon. The comparative samples were also examined in terms of film separation therein. The film separation was examined by visual observation and change in color (because portions with film separation becomes clouded or changed in color).

As a result, in the samples with a Ti film formed under conditions according to the first or second embodiment, no film separation by visual observation or change in color was found in either case where a TiN film was formed by the third or fourth embodiment. In other wards, it was confirmed that no film separation was caused in these samples. On the other hand, in the comparative samples with a Ti film formed by the conventional method, film separation and change in color were found in either case where a TiN film was formed by the third or fourth embodiment. Further, it was confirmed that the Ti/TiN film samples with a Ti film formed under conditions according to the first or second embodiment had a lower electric resistivity and better film quality, as compared to the comparative examples according to the conventional method.

Next, an explanation will be given, with reference to FIG. 4, of a method of forming a Ti/TiN film only by the Ti film formation apparatus 3 without using the TiN film formation apparatus 4.

In this embodiment, the heater 55 and heater 96 are maintained in the same conditions as in the precoating. In this state, as shown in the timing chart of FIG. 12, at first, an RF power is applied from the RF power supply 84 to the showerhead 60. At the same time, $TiCl_4$ gas, Ar gas, $H_2$ gas, and Ar gas are supplied respectively from the gas supply sources 72, 73, 74, and 76. By doing so, a first step is performed to turn these gases into plasma (first plasma), and maintain this state for 1 to 20 seconds, and preferably 2 to 10 seconds.

Then, only the $TiCl_4$ gas is stopped, while the RF power, Ar gas, and $H_2$ gas are maintained. By doing so, a second step, which is a reducing process using plasma (second plasma) of Ar gas and $H_2$ gas, is performed for 2 to 60 seconds, and preferably 5 to 40 seconds. This second plasma process is preferably set to have a longer processing time than the first plasma process.

The first and second steps are alternately repeated a plurality of times, and preferably three times or more, such as 12 to 24 times, to form a Ti film at first. At this time, $TiCl_4$ gas is set at a flow rate of 0.001 to 0.03 L/min (1 to 30 sccm), $H_2$ gas at a flow rate of 0.5 to 5 L/min (500 to 5000 sccm), and Ar gas at a flow rate of 0.3 to 3.0 L/min (300 to 3000 sccm), approximately. The interior of the chamber 51 is set at a pressure of about 66.6 to 1333 Pa, and preferably about 133.3 to 666.5 Pa. The RF power supply 84 is set at a power of about 200 to 2000W, and preferably about 500 to 1500W.

Then, the RF power and gases are stopped to finish the Ti film formation, and TiN film formation is subsequently started. In this TiN film formation, the susceptor 52 is heated up to a temperature of 450 to 550°C by the heater 55. The showerhead 60 is heated up to a temperature of 440°C or more, such as about 460°C, by the heater 96.

Then, as shown in FIG. 12, at first, an RF power is applied from the RF power supply 84 to the showerhead 60. At the same time, $TiCl_4$ gas, Ar gas, $H_2$ gas, and Ar gas are supplied respectively from the gas supply sources 72, 73, 74, and 76. By doing so, a third step is performed to turn these gases into plasma (third plasma), and maintain this state for 2 to 20 seconds, and preferably 4 to 12 seconds.

Then, the $TiCl_4$ gas and RF power are stopped, while the Ar gas and $H_2$ gas are maintained. Then, $NH_3$ gas starts being supplied from the $NH_3$ gas supply source 75, and an RF power restarts being supplied. By doing so, a fourth step, which is a reducing and nitriding process using plasma (fourth plasma) of Ar gas, $H_2$ gas, and $NH_3$ gas, is performed for 2 to 30 seconds, and preferably 4 to 20 seconds.

The third and fourth steps are alternately repeated a plurality of times, and preferably three times or more, such as 12 to 24 times, to form a TiN film on the Ti film. At this time, $TiCl_4$ gas is set at a flow rate of 0.005 to 0.05 L/min (5 to 50 sccm), $H_2$ gas at a flow rate of 0.5 to 5 L/min (500 to 5000 sccm), $NH_3$ gas at a flow rate of 0.3 to 2.0 L/min (300 to 2000 sccm), and Ar gas at a flow rate of 0.3 to 3.0 L/min (300 to 3000 sccm), approximately. The interior of the chamber 51 is set at a pressure of about 66.6 to 1333 Pa, and preferably about 40 to 1333 Pa, and preferably about 66.6 to 666.5 Pa. The RF power supply 84 is set at a power of about 200 to 2000W, and preferably about 500 to 1500W.

The gas switching for this is performed by valve switching under the control of the controller 98. At this time, in accordance with instructions from the controller 106, the matching network 100 of the electron matching type follows change in plasma and automatically matches the plasma impedance with the transmission line impedance. As a consequence, even if the plasma state varies due to gas switching, a good plasma state is maintained.

As described above, a first step of performing film formation using $TiCl_4$ gas + Ar gas + $H_2$ gas + plasma, and a second step of performing reduction using Ar gas + $H_2$ gas + plasma are alternately performed a plurality of times in a relatively short time, to form a Ti film. Subsequently, a third step of performing film formation using $TiCl_4$ gas + Ar gas + $H_2$ gas + plasma, and a fourth step of performing reduction and nitridation using $NH_3$ gas + Ar gas + $H_2$ gas + plasma are alternately performed a plurality of times in a relatively short time, to form a TiN film. In this case, the reducing action of reducing Ti compounds is enhanced, and nitridation effectively takes place. As a consequence, the residual chlorine concentration in the Ti film is thereby decreased. Particularly, where the wafer temperature is as low as 450°C or less, residual chlorine in the Ti film and TiN film tends to increase. Even if such a low temperature is used, the sequence according to this embodiment can decrease the residual chlorine concentration, thereby providing a high quality Ti/TiN multi-layered structure with a low resistivity.

Further, conventionally, two kinds of film formation apparatuses are required to form a Ti/TiN multilayered structure. By contrast, according to this embodiment, a Ti/TiN multi-layered structure can be sequentially formed by one film formation apparatus, which is very efficient.

In order to form a good TiN film in the third and fourth steps, a Ti film formed in the third step has to be reliably nitrided in the fourth step. For this, the $NH_3$ gas flow rate and the processing time of the fourth step are preferably controlled. Particularly, the fourth step is preferably set to have a longer processing time than the third step.

In the embodiments described with reference to FIGS. 1 to 14, when a Ti film or Ti/TiN film is formed by repetition of the first and second steps, or repetition of third and fourth step, the target substrate may be set at a temperature of 300 to 700°C, and preferably 450°C or less. If the worktable and gas discharge member can be independently heated, it is possible to control the gas discharge member to be always heated at a temperature of 450°C or more, so as to prevent the gas discharge member from causing film separation, without reference to the temperature of a target substrate. This arrangement is effective particularly where the temperature of a target substrate is controlled at a low temperature of 300 to 550°C by the worktable being heated. Incidentally, in any of the first to fourth steps, a rare gas, such as Ar, He, or Xe, may be supplied into the process chamber.

The present invention is not limited to the embodiments described, and may be modified in various manners. For example, although the embodiments are exemplified by Ti film formation, the present invention is not limited thereto, and may be applied to other film formation utilizing plasma CVD. The film formation gas is not limited to $TiCl_4$, and may comprise a metal halogen compound, such as TiF4, TiI4, or TaCl4, a metal organic compound, such as Ti or Ta, or another compound. The reducing gas is also not limited to $H_2$. The gas containing N and H is not limited to $NH_3$ gas, and may comprise a mixture gas of $N_2$ and $H_2$, or a hydrazine family gas, such as MMH. Further, in the embodiments described above, the target substrate is exemplified by a semiconductor wafer. However, the target substrate may be a glass substrate for an LCD or FPD.

Industrial Applicability

According to the present invention, there is provided a film formation method and apparatus utilizing plasma CVD, which allow a film to be formed at a low temperature, while decreasing residual substances in the film even if a low temperature is used for the film formation.

**Claims**

1. A film formation method utilizing plasma CVD to form a predetermined thin film on a target substrate, the method comprising:

   a first step of generating first plasma within a process chamber that accommodates the substrate while supplying a compound gas containing a component of the thin film and a reducing gas into the process chamber; and
   a second step of generating second plasma within the process chamber while supplying the reducing gas into the process chamber, subsequently to the first step,

   wherein the first and second steps are alternately performed each at least once.

2. The method according to claim 1, wherein the second step is arranged to supply a nitriding gas along with the reducing gas into the process chamber.

3. The method according to claim 1, further comprising a step of generating third plasma within the process chamber to perform a nitriding process while supplying the reducing gas and a nitriding gas into the process chamber, after the first and second steps are alternately performed each at least once.

4. The method according to claim 1, wherein an RF power is applied to at least one of a pair of parallel-plate electrodes to generate plasma, and plasma impedance is matched with transmission line impedance by a matching network of an electron matching type.

5. The method according to claim 1, wherein the second step is performed for a longer time than the first step.

6. A film formation method utilizing plasma CVD to form a predetermined thin film on a target substrate, the method comprising:

   a first step of generating first plasma within a first process chamber that accommodates the substrate while supplying a Ti compound gas and a reducing gas into the first process chamber; and
   a second step of generating second plasma within the first process chamber while stopping supply of the Ti compound gas and supplying the reducing gas into the first process chamber, subsequently to the first step,

   wherein the first and second steps are alternately performed each at least once to form a Ti film on the substrate.

7. The method according to claim 6, further comprising a step of generating third plasma within the first process chamber to perform a nitriding process while supplying the reducing gas and a gas containing N and H into the first process chamber, after the first and second steps are alternately performed each at least once.

8. The method according to claim 6, further comprising a second stage after a first stage of forming the Ti film, the second stage comprising:

a third step of generating third plasma within a second process chamber that accommodates the substrate while supplying a Ti compound gas and a reducing gas into the second process chamber; and
a fourth step of generating fourth plasma within the second process chamber while stopping supply of the Ti compound gas and supplying the reducing gas and a gas containing N and H into the second process chamber, subsequently to the third step,

wherein the third and fourth steps are alternately performed each at least once to form a TiN film on the Ti film.

9. The method according to claim 8, wherein the first and second process chambers are the same process chamber, and the first and second stages are sequentially performed.

10. The method according to claim 8, wherein the fourth step is performed for a longer time than the third step.

11. The method according to claim 6, wherein the Ti compound gas comprises $TiCl_4$ gas, and the reducing gas comprises $H_2$ gas.

12. The method according to claim 6, wherein the substrate is placed on a worktable and heated at a temperature of 300 to 700°C during film formation.

13. The method according to claim 12, wherein a process gas is supplied from a gas discharge member disposed opposite the worktable and the gas discharge member is heated at a temperature of 440°C or more during film formation.

14. The method according to claim 13, wherein the substrate is heated at a temperature of 300 to 550°C by the worktable during film formation.

15. The method according to claim 6, further comprising a step of removing a natural oxide film on an underlayer surface before the first step.

16. The method according to claim 6, wherein an RF power is applied to at least one of a pair of parallel-plate electrodes to generate plasma, and plasma impedance is matched with transmission line impedance by a matching network of an electron matching type.

17. The method according to claim 6, wherein the second step is performed for a longer time than the first step.

18. A film formation method utilizing plasma CVD to form a predetermined thin film on a target substrate, the method comprising:

a first step of generating first plasma within a first process chamber that accommodates the substrate while supplying a Ti compound gas and a reducing gas into the first process chamber; and
a second step of generating second plasma within the first process chamber while stopping supply of the Ti compound gas and supplying the reducing gas and a gas containing N and H into the first process chamber, subsequently to the first step,

wherein the first and second steps are alternately performed each at least once to form a Ti film or Ti/TiN film on the substrate.

19. The method according to claim 18, wherein the Ti compound gas comprises $TiCl_4$ gas, and the reducing gas comprises $H_2$ gas.

20. The method according to claim 18, further comprising a step of generating third plasma within the first process chamber to perform a nitriding process while supplying the reducing gas and a gas containing N and H into the first process chamber, after the first and second steps are alternately performed each at least once.

21. The method according to claim 18, further comprising,
after a first stage of forming the Ti film or Ti/TiN film,
a second stage of supplying a Ti compound gas and a gas containing N and H into a second process chamber that accommodates the substrate, to form a TiN film on the Ti film or Ti/TiN film.

22. The method according to claim 21, wherein the second stage comprises:

a third step of supplying the Ti compound gas and the gas containing N and H into the second process chamber; and
a fourth step of stopping supply of the Ti compound gas and supplying the gas containing N and H into the second process chamber, subsequently to the third step,

    wherein the third and fourth steps are alternately performed each at least once.

23. The method according to claim 22, wherein the second stage further comprises a step of supplying a purge gas into the second process chamber between the third step and the fourth step.

24. The method according to claim 21, wherein the Ti compound gas comprises $TiCl_4$ gas, the reducing gas comprises $H_2$ gas, and the gas containing N and H comprises $NH_3$ gas.

25. The method according to claim 21, wherein $H_2$ gas is supplied into a corresponding process chamber during one or both of the first and second stages.

26. The method according to claim 21, wherein the first and second stages are sequentially performed without bringing the substrate out of a vacuum atmosphere.

27. A film formation method utilizing plasma CVD to form a Ti/TiN film on a target substrate, the method comprising:

    a first stage of forming a Ti film, the first stage comprising

        a first step of generating first plasma within a first process chamber that accommodates the substrate while supplying a Ti compound gas and a reducing gas into the first process chamber, and
        a second step of generating second plasma within the first process chamber while stopping supply of the Ti compound gas and supplying the reducing gas into the first process chamber, subsequently to the first step,

    wherein the first and second steps are alternately performed each at least once; and
    a second stage of supplying a Ti compound gas and a gas containing N and H into a second process chamber that accommodates the substrate, to form a TiN film on the Ti film, after the first stage.

28. The method according to claim 27, wherein the first stage further comprises a step of generating third plasma within the first process chamber to perform a nitriding process while supplying the reducing gas and a gas containing N and H into the first process chamber, after the first and second steps are alternately performed each at least once.

29. The method according to claim 27, wherein the second stage comprises:

    a third step of supplying the Ti compound gas and the gas containing N and H into the second process chamber; and
    a fourth step of stopping supply of the Ti compound gas and supplying the gas containing N and H into the second process chamber, subsequently to the third step,

    wherein the third and fourth steps are alternately performed each at least once.

30. The method according to claim 27, wherein the Ti compound gas comprises $TiCl_4$ gas, the reducing gas comprises $H_2$ gas, and the gas containing N and H comprises $NH_3$ gas.

31. The method according to claim 27, wherein $H_2$ gas is supplied into a corresponding process chamber during one or both of the first and second stages.

32. The method according to claim 27, wherein the first and second stages are sequentially performed without bringing the substrate out of a vacuum atmosphere.

33. The method according to claim 27, wherein the substrate is placed on a worktable and heated at a temperature of 300 to 700°C during film formation.

34. The method according to claim 33, wherein a process gas is supplied from a gas discharge member disposed opposite the worktable and the gas discharge member is heated at a temperature of 440°C or more during film formation.

35. The method according to claim 34, wherein the substrate is heated at a temperature of 300 to 550°C by the worktable during film formation.

36. The method according to claim 27, further comprising a step of removing a natural oxide film on an underlayer surface before the first step.

37. The method according to claim 27, wherein an RF power is applied to at least one of a pair of parallel-plate electrodes to generate plasma, and plasma impedance is matched with transmission line impedance by a matching network of an electron matching type.

**38.** The method according to claim 27, wherein the second step is performed for a longer time than the first step.

**39.** A film formation apparatus utilizing plasma CVD to form a predetermined thin film on a target substrate, the apparatus comprising:

a process chamber configured to accommodate the target substrate;
a worktable configured to place the substrate thereon within the process chamber;
a gas supply system configured to supply a compound gas containing a component of the thin film and a reducing gas into the process chamber;
a pair of electrodes configured to generate plasma within the process chamber;
an RF power supply configured to apply an RF power to at least one of the pair of electrodes;
a matching network of an electron matching type configured to match plasma impedance with transmission line impedance;
a group of valves configured to switch ON/OFF of the compound gas and the reducing gas; and
a control system configured to control the RF power supply and the group of valves, so as to alternately perform first and second steps each at least once, wherein the first step is arranged to generate first plasma within the process chamber while supplying the compound gas and the reducing gas into the process chamber, and the second step is arranged to generate second plasma within the process chamber while supplying the reducing gas into the process chamber, subsequently to the first step.

FIG.1

FIG. 2

22

24
23
21

20a
20

FIG. 3

2

32

38

40

37

Gas supply mechanism

42

35    45    W

G

41

33    36

31

FIG. 3

39

34

Power supply

43    44

Exhaust unit

46

F I G. 4

EP 1 591 559 A1

FIG. 5

FIG.6

FIG. 7

FIG. 9

FIG. 8

FIG.10

EP 1 591 559 A1

One cycle

TiCl₄

NH₃

N₂ purge

First step
Purge
Second step
Purge

FIG. 11

TiCl₄

H₂

Ar

NH₃

RF

First step
Second step

Ti film formation

Third step
Fourth step

TiN film formation

FIG. 12

| Ti film | First embodiment | | | Second embodiment | | Prior art |
|---|---|---|---|---|---|---|
| Item | First step | Second step | Nitridation | First step | Second step | – |
| Temperature (℃) | 460 | 460 | 460 | 460 | 460 | 460 |
| Pressure (Pa) | 667 | 667 | 667 | 667 | 667 | 667 |
| $TiCl_4$ (mL/min) | 12 | 0 | 0 | 12 | 0 | 12 |
| Ar (mL/min) | 1600 | 1600 | 1600 | 1600 | 1600 | 1600 |
| $H_2$ (mL/min) | 4000 | 4000 | 2000 | 4000 | 2000 | 4000 |
| $NH_3$ (mL/min) | 0 | 0 | 1500 | 0 | 1500 | 0 |
| RF power (W) | 800 | 800 | 800 | 800 | 800 | 800 |
| One processing time (sec) | 4 | 30 | 30 | 4 | 30 | 30 |
| Number of cycles | 18 | 18 | 1 | 19 | 19 | 1 |

# FIG.13

| TiN film | Third embodiment | Fourth embodiment | |
|---|---|---|---|
| Item | – | First step | Second step |
| Temperature (℃) | 500 | 500 | 500 |
| Pressure (Pa) | 667 | 260 | 260 |
| $TiCl_4$ (mL/min) | 60 | 60 | 0 |
| $NH_3$ (mL/min) | 60 | 60 | 1000 |
| $N_2$ (mL/min) | 1000 | 340 | 1000 |
| Initial film formation time (sec) | 30 | 15.8 | 5 |
| One processing time (sec) | – | 6.9 | 5 |
| Number of cycles | 1 | 15 | 15 |

# FIG.14

F I G. 1 5

F I G. 1 6

# EP 1 591 559 A1

<table>
<tr><td colspan="2" align="center"><strong>INTERNATIONAL SEARCH REPORT</strong></td><td>International application No.<br>PCT/JP03/15561</td></tr>
</table>

**A. CLASSIFICATION OF SUBJECT MATTER**
Int.Cl$^7$ C23C16/455, C23C16/08, C23C16/34, H01L21/28, H01L21/285

According to International Patent Classification (IPC) or to both national classification and IPC

**B. FIELDS SEARCHED**

Minimum documentation searched (classification system followed by classification symbols)
Int.Cl$^7$ C23C16/00-16/56, H01L21/205, H01L21/28-21/285, H01L21/31

Documentation searched other than minimum documentation to the extent that such documents are included in the fields searched
Jitsuyo Shinan Koho      1922–1996   Jitsuyo Shinan Toroku Koho   1996–2004
Kokai Jitsuyo Shinan Koho   1971–2004   Toroku Jitsuyo Shinan Koho   1994–2004

Electronic data base consulted during the international search (name of data base and, where practicable, search terms used)
JSTPlus(JOIS)

**C. DOCUMENTS CONSIDERED TO BE RELEVANT**

| Category* | Citation of document, with indication, where appropriate, of the relevant passages | Relevant to claim No. |
|---|---|---|
| A | S.M. ROSSNAGEL, Plasma-enhanced atomic layer deposition of Ta and Ti for interconnect diffusion barriers, J.Vac.Sic.Technol.B, Jul/Aug 2000, Vol.18, No.4, pages 2016 to 2020 | 1-39 |
| A | WO 00/63957 A1 (GENITECH, INC.), 26 October, 2000 (26.10.00), Full text & KR 2000049298 A    & EP 1092233 A1 & JP 2003-521579 A | 1-39 |
| A | JP 4-361531 A (Fujitsu Ltd.), 15 December, 1992 (15.12.92), Full text (Family: none) | 1-39 |

☒ Further documents are listed in the continuation of Box C.    ☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>08 March, 2004 (08.03.04) | Date of mailing of the international search report<br>23 March, 2004 (23.03.04) |
| Name and mailing address of the ISA/<br>Japanese Patent Office | Authorized officer |
| Facsimile No. | Telephone No. |

Form PCT/ISA/210 (second sheet) (July 1998)

27

## INTERNATIONAL SEARCH REPORT

| International application No. |
| --- |
| PCT/JP03/15561 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 6-163434 A  (Shinko Seiki Co., Ltd.),<br>10 June, 1994 (10.06.94),<br>Full text<br>(Family: none) | 1-39 |
| P,X | JP 2003-109914 A  (Fujitsu Ltd.),<br>11 April, 2003 (11.04.03),<br>Claims; Par. Nos. [0023], [0029] to [0037], [0046]<br>(Family: none) | 1,2,6,9,11,<br>15,18,19 |

Form PCT/ISA/210 (continuation of second sheet) (July 1998)